# EUROPEAN PATENT SPECIFICATION

(11) **EP 4 586 312 B1**
(45) Date of publication and mention of the grant of the patent: **12.08.2026**
(21) Application number: 25150559.0
(22) Date of filing: 07.01.2025
(51) Int. Cl.: H10W 40/25, H10W 40/60

(54) **MULTILAYER SUBSTRATES AND METHODS FOR MANUFACTURING SAME, POWER MODULES AND METHODS FOR MANUFACTURING SAME, AND ELECTRICAL SYSTEMS**
MEHRSCHICHTIGE SUBSTRATE UND VERFAHREN ZUR HERSTELLUNG DAVON, LEISTUNGSMODULE UND VERFAHREN ZUR HERSTELLUNG DAVON SOWIE ELEKTRISCHE SYSTEME
SUBSTRATS MULTICOUCHES ET LEURS PROCÉDÉS DE FABRICATION, MODULES DE PUISSANCE ET PROCÉDÉS DE FABRICATION DE CEUX-CI, ET SYSTÈMES ÉLECTRIQUES

(30) Priority: 09.01.2024 CN 202410038784; 26.12.2024 US 202419002104
(43) Date of publication of application: 16.07.2025
(73) Proprietor: Shenzhen STS Microelectronics Co., Ltd., Shenzhen 518048 (CN)
(72) Inventor: CHEN, Qiao, SHENZHEN, 518040 (CN); ZHENG, Nan Nan, SHENZHEN, 518038 (CN); LIANG, Lin, SHENZHEN, 518048 (CN)
(74) Representative: Casalonga

(56) References cited:
- WO-A1-2022/226142
- US-A1- 2006 221 576
- US-A1- 2014 131 846

## Description

### Technical field

The present disclosure relates to the field of package, and more specifically, to multilayer substrates and methods of manufacturing the same, power modules and methods of manufacturing the same, and electrical systems.

### Background

Packages of power modules such as Intelligent Power Modules (IPM) are receiving more and more attention. In IPM packages, power-side devices are mounted on multilayer substrates, such as Direct Bond Copper (DBC) substrates, so as to improve heat dissipation performance and provide electrical connections, as examplified by US 2014/131846 A1 and WO 2022/226142 A1.

The power modules require an encapsulation process for molding. One approach is to use transfer molding. Existing transfer molding modules (TMM) use retract pins to secure a multilayer substrate to be packaged, to prevent displacement of the multilayer substrate to be packaged caused by turbulence and overflow of liquid resin used during a molding process. However, the use of the retract pins may inevitably result in several blind holes left in the transfer molding module after the resin has cured. The blind holes and an packaging layer around the blind holes are insufficient in thickness, which may cause leakage or abnormal discharge, and then cause the transfer molding module to be prone to failure or damage.

Therefore, there is a need of improved packages and the methods of manufacturing (packaging methods) thereof in the related arts.

### Brief Summary

One of objectives of the present disclosure is to provide improved multilayer substrates and methods of manufacturing the same, improved power modules and methods of manufacturing the same, and improved electrical systems.

According to the invention of the present disclosure, there is provided a multilayer substrate, comprising: an insulating material layer; a first metal layer attached to the insulating material layer on one surface of the insulating material layer; and a second metal layer attached to the insulating material layer on another opposite surface of the insulating material layer. The second metal layer comprises:
a first portion overlapping the insulating material layer and used for attaching chip(s) thereon; and a second portion extending outwards from the first portion and extending beyond the insulating material layer at least on opposite first and second sides of the second metal layer. The second portion has at least one pair of first notches extending inwards from edges, and each pair of first notches arelocated at corresponding positions on the first and second sides of the second metal layer, respectively.

The first metal layer comprises: a first portion, overlapping the insulating material layer; and a second portion, extending outwards from the first portion and extending beyond the insulating material layer at least on opposite first and second sides of the first metal layer. The second portion has at least one pair of second notches extending inwards from edges. Each pair of second notches are located at corresponding positions of the first and second sides of the first metal layer, respectively.

According to the invention of the present disclosure, at least one notch of each first notch and a corresponding second notch is matched with a shape of a corresponding portion of a clamping tool, so that the at least one notch is capable of firmly engaging the clamping tool.

According to some embodiments of the present disclosure, vertical projections of each pair of second notches on the second metal layer overlap at least portions of one corresponding pair of first notches of the second metal layer that are used for engaging clamping tools.

According to some embodiments of the present disclosure, a width of an open edge of the first notch is greater than that of an inner portion of the first notch in a direction parallel to the open edge, and a width of an open edge of the second notch is greater than that of an inner portion of the second notch in a direction parallel to the open edge.

According to some embodiments of the present disclosure, a width of an open edge of the first notch is less than that of at least part of an inner portion of the first notch in a direction parallel to the open edge, and a width of an open edge of the second notch is less than that of at least part of an inner portion of the second notch in a direction parallel to the open edge.

According to some embodiments of the present disclosure, the first notch comprises two inner edges extending inward facing each other. The second notch comprises two inner edges extending inward facing each other. Each inner edge of the first notch and the second notch is configured such that: with respect to an axis passing through an innermost point of the inner edge and parallel to a direction in which the respective notch extends inward, the inner edge has a slope gradually decreasing as the inner edge extends toward the innermost point.

According to some embodiments of the present disclosure, each inner edge has one of the following shapes: an arc which is non-continuously differentiable; and a plurality of line segments having discontinuous slopes and connected in sequence.

According to some embodiments of the present disclosure, the inner edge of the first notch is arc-shaped; and the inner edge of the second notch is arc-shaped.

According to some embodiments of the present disclosure, the first notch is part of a circle or part of an ellipse and the second notch is part of a circle or part of an ellipse; or, the first notch is in a shape of a trapezoid, square, rectangle, or a combination thereof and the second notch is in a shape of a trapezoid, square, rectangle, or a combination thereof.

According to some embodiments of the present disclosure, projections of the at least one pair of first notches on a plane where the insulating material layer is located do not overlap the insulating material layer.

According to some embodiments of the present disclosure, the insulating material layer comprises a plurality of segments separated from each other. The first metal layer is integrated. The second metal layer comprises a plurality of segments separated from each other, each of which comprises at least part of the first portion and at least part of the second portion. The segments of the second metal layer are attached to corresponding segments of the insulating material layer, respectively.

According to some embodiments of the present disclosure, the insulating material layer is a ceramic substrate. The first and second metal layers are copper layers attached on top and bottom surfaces of the ceramic substrate, respectively. The chip(s) include(s) a power chip.

According to some embodiments of the present disclosure, the first and second metal layers are attached to the insulating material layer by sintering, brazing, soldering, or curing.

According to another aspect of the present disclosure, there is provided a method of manufacturing multilayer substrate(s), comprising: providing an insulating material layer, a first metal layer and a second metal layer, and disposing the insulating material layer between the first metal layer and the second metal layer, wherein: the first metal layer comprises: a first portion overlapping the insulating material layer, and a second portion extending outwards from the first portion and extending beyond the insulating material layer at least on opposite first and second sides of the first metal layer, and the second metal layer comprises: a first portion overlapping the insulating material layer and used for attaching chip(s) thereon, and a second portion extending outwards from the first portion and extending beyond the insulating material layer at least on opposite first and second sides of the second metal layer; attaching the first and second metal layers onto opposite two surfaces of the insulating material layer; performing patterning process on the second metal layer to form, in the second portion of the second metal layer, at least one pair of first notches extending inwards from edges, each pair of first notches being located at corresponding positions of the first and second sides of the second metal layer, respectively; performing patterning process on the first metal layer to form, in the second portion of the first metal layer, at least one pair of second notches extending inwards from edges. Each pair of second notches are located at corresponding positions of the first and second sides of the first metal layer, respectively; and sawing the first metal layer to segment a plurality of multilayer substrates.

According to some embodiments of the present disclosure, the patterning of the first layer is performed so that at least one notch of each first notch and a corresponding second notch is matched with a shape of a corresponding portion of a clamping tool, so that the at least one notch is capable of firmly engaging the clamping tool.

According to some embodiments of the present disclosure, vertical projections of each pair of second notches on the second metal layer overlap at least portions of one corresponding pair of first notches of the second metal layer that are used for engaging clamping tools.

According to some embodiments of the present disclosure, a width of an open edge of the first notch is greater than that of an inner portion of the first notch in a direction parallel to the open edge, and a width of an open edge of the second notch is greater than that of an inner portion of the second notch in a direction parallel to the open edge.

According to some embodiments of the present disclosure, a width of an open edge of the first notch is less than that of at least part of an inner portion of the first notch in a direction parallel to the open edge, and a width of an open edge of the second notch is less than that of at least part of an inner portion of the second notch in a direction parallel to the open edge.

According to some embodiments of the present disclosure, the first notch comprises two inner edges extending inward facing each other. The second notch comprises two inner edges extending inward facing each other. Each inner edge of the first notch and the second notch is configured such that: with respect to an axis passing through an innermost point of the inner edge and parallel to a direction in which the respective notch extends inward, the inner edge has a slope gradually decreasing as the inner edge extends toward the innermost point.

According to some embodiments of the present disclosure, each inner edge has one of the following shapes: an arc which is non-continuously differentiable; and a plurality of line segments having discontinuous slopes and connected in sequence.

According to some embodiments of the present disclosure, the inner edge of the first notch is arc-shaped; and the inner edge of the second notch is arc-shaped.

According to some embodiments of the present disclosure, the first notch is part of a circle or part of an ellipse and the second notch is part of a circle or part of an ellipse; or the first notch is in a shape of a trapezoid, square, rectangle, or a combination thereof and the second notch is in a shape of a trapezoid, square, rectangle, or a combination thereof.

According to some embodiments of the present disclosure, projections of the at least one pair of first notches on a plane where the insulating material layer is located do not overlap the insulating material layer.

According to some embodiments of the present disclosure, the method of manufacturing further comprises: before attaching the first and second metal layers onto opposite two surfaces of the insulating material layer, performing segmenting process on the insulating material layer to segment the insulating material layer into a plurality of segments separated from each other. The first metal layer is integrated. The performing patterning process on the second metal layer further comprises: patterning the second metal layer such that it comprises a plurality of segments separated from each other. Each segment of the second metal layer comprises at least part of the first portion and at least part of the second portion, and is attached to corresponding segment(s) of the insulating material layer, respectively.

According to some embodiments of the present disclosure, the insulating material layer is a ceramic substrate. The first and second metal layers are copper layers. The chip(s) include(s) a power chip.

According to some embodiments of the present disclosure, the attaching the first and second metal layers onto opposite two surfaces of the insulating material layer is accomplished by sintering, brazing, soldering, or curing.

According to another aspect of the present disclosure, there is provided a power module, comprising: the multilayer substrate as described hereinbefore; and a chip, comprising power semiconductor device(s). The chip is attached to the first portion of the second metal layer of the multilayer substrate.

According to some embodiments of the present disclosure, the power module further comprises: a lead frame comprising lead(s) attached to the second metal layer; and a molding compound at least encapsulating at least part of the multilayer substrate, the chip, and at least part of the lead frame. The molding compound leaves a surface of the first metal layer of the multilayer substrate that is far away from the chip exposed. The molding compound has therein disposed at least one pair of circular holes. At least part of vertical projections of the at least one pair of circular holes on the second metal layer substantially overlap one corresponding pair of first notches of the second metal layer, and the at least one pair of circular holes are usable for mounting screws.

According to another aspect of the present disclosure, there is provided a method of manufacturing a power module, comprising: providing the multilayer substrate as described hereinbefore; attaching a chip comprising power semiconductor device(s) onto the first portion of the second metal layer of the multilayer substrate; disposing the multilayer substrate and the chip, which are attached together, in a lead frame; attaching lead(s) of the lead frame to the second metal layer of the multilayer substrate; encapsulating at least part of the multilayer substrate, the chip, and at least part of the lead frame using a molding compound based on a transfer molding process; and cutting an excess portion of the lead frame to obtain a power module in package,. The molding compound leaves a surface of the first metal layer of the multilayer substrate that is far away from the chip exposed.

According to some embodiments of the present disclosure, the encapsulating at least part of the multilayer substrate, the chip, and at least part of the lead frame using a molding compound based on a transfer molding process comprises: clamping the at least one pair of second notches of the second portion of the first metal layer and the at least one pair of first notches of the second portion of the second metal layer of the multilayer substrate using at least one pair of clamping tools to secure the multilayer substrate, wherein each clamping tool of each pair of clamping tools clamps one notch of one corresponding pair of first notches and one notch of one corresponding pair of second notches; injecting the molding compound; and after the molding compound has cured, removing the at least one pair of clamping tools.

According to some embodiments of the present disclosure, the removing the at least one pair of clamping tools leaves at least one pair of circular holes in the molding compound At least part of vertical projections of each pair of circular holes on the second metal layer substantially overlap one corresponding pair of first notches of the second metal layer, and the at least one pair of circular holes being usable for mounting screws.

According to another aspect of the present disclosure, there is provided an electrical system, comprising the power module as described hereinbefore.

Other features of the present disclosure and advantages thereof will become more apparent from the following detailed description of exemplary embodiments thereof, which proceeds with reference to the accompanying drawings.

### Brief Description of the Drawings

The accompanying drawings, which constitute part of this specification, illustrate embodiments of the present disclosure and together with the description, serve to explain the principles of the present disclosure.

The present disclosure may be more clearly understood according to the following detailed description with reference to the accompanying drawings, in which:
Fig. 1 illustrates a schematic top view from one side of a multilayer substrate according to some embodiments of the present disclosure;
Fig. 2 illustrates a schematic top view from another side of a multilayer substrate according to some embodiments of the present disclosure;
Figs. 3A to 3D illustrate schematic shape diagrams of notches according to some embodiments of the present disclosure;
Fig. 3E schematically illustrates a schematic diagram of clamping a multilayer substrate using positioning rods as clamping components;
Fig. 4 illustrates an exemplary flow diagram of a method of manufacturing multilayer substrate(s) according to embodiments of the present disclosure;
Figs. 5A to 5D schematically illustrate schematic diagrams of devices corresponding to some of steps of the method of manufacturing shown in Fig. 4;
Fig. 6 illustrates a schematic diagram of a power module according to some embodiments of the present disclosure;
Fig. 7 illustrates an exemplary flow diagram of a method of manufacturing a power module according to embodiments of the present disclosure; and
Figs. 8A to 8C schematically illustrates schematic diagrams of devices corresponding to some of steps of the method of manufacturing shown in Fig. 7.

Note that in the embodiments described below, the same reference numbers are sometimes shared between different drawings to denote the same portions or portions having the same functions, and a repetitive description thereof will be omitted. In some cases, similar items are denoted using similar reference numbers and letters, and thus, once a certain item is defined in a drawing, it does not need to be further discussed in subsequent drawings.

For ease of understanding, positions, sizes, ranges, and the like of the various structures shown in the drawings and the like sometimes do not indicate actual positions, sizes, ranges, and the like. Therefore, the present disclosure is not limited to the positions, sizes, ranges, and the like disclosed in the drawings.

### Detailed Description

Various exemplary embodiments of the present disclosure will now be described in detail with reference to the accompanying drawings. It should be noted that: relative arrangements, numerical expressions and numerical values of components and steps set forth in these embodiments do not limit the scope of the present disclosure unless specifically stated otherwise. In addition, techniques, methods, and apparatus known to one of ordinary skill in the related art may not be discussed in detail but should be considered as part of the granted specification where appropriate.

It should be understood that the following description of at least one exemplary embodiment is merely illustrative in nature and is in no way used as any limitation on this disclosure and its application or uses. That is, structures and methods herein are shown in exemplary manners to illustrate different embodiments of the structures and methods of the present disclosure. Those skilled in the art will understand, however, that they are merely illustrative of the exemplary manners in which this disclosure may be implemented, rather than exhaustive manners. Furthermore, the drawings are not necessarily drawn to scale, and some features may be zoomed in to show details of specific components.

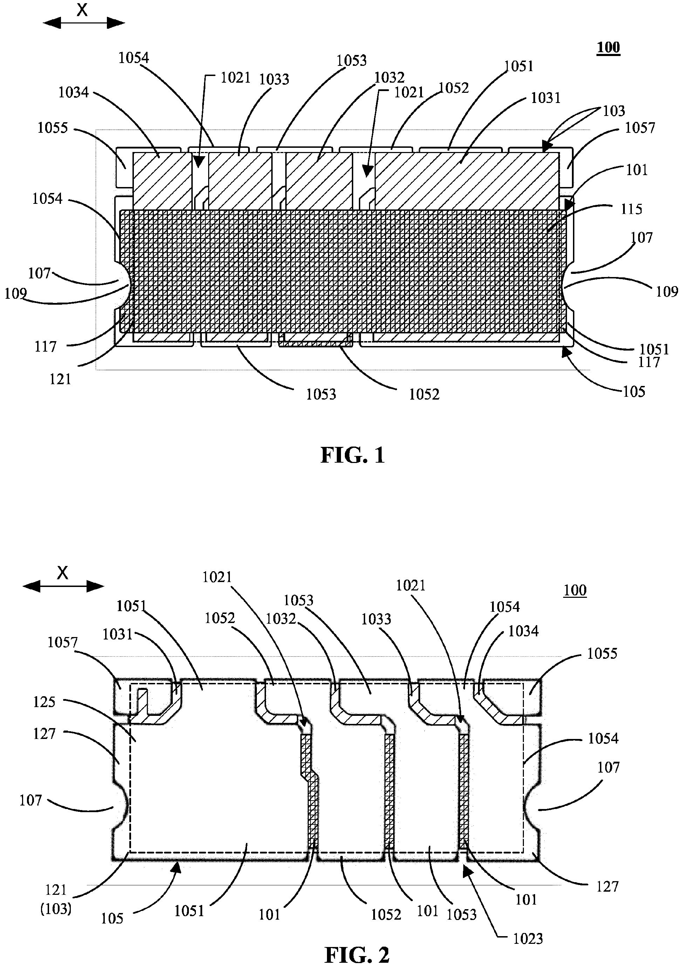

Fig. 1 illustrates a schematic top view from one side of a multilayer substrate 100 according to some embodiments of the present disclosure, and Fig. 2 illustrates a schematic top view from the other side of the multilayer substrate 100 according to some embodiments of the present disclosure. The multilayer substrate 100 will be described in conjunction with Fig. 1 and Fig. 2 in the following.

As shown in Fig. 1, the multilayer substrate 100 may comprise a first metal layer 101, an insulating material layer 103, and a second metal layer 105. The first metal layer 101 is disposed on one surface (e.g., a bottom surface or lower surface) of the insulating material layer 103, and is attached to the insulating material layer 103. The second metal layer 105 is disposed on another opposite surface (e.g., a top surface or upper surface) of the insulating material layer 103, and is attached to the insulating material layer 103. In some embodiments, the first metal layer 101 and the second metal layer 105 may be attached to the insulating material layer 103 by, for example, but not limited to, sintering, brazing, soldering, or curing.

The second metal layer 105 may comprise a first portion 125, i.e., a portion surrounded by a dashed box 121, as shown in Fig. 2. The dashed box here schematically shows an outline of the insulating material layer 103. In addition, for ease of comparison, the dashed box 121 is also shown in Fig. 1. The first portion 125 of the second metal layer 105 overlaps the insulating material layer 103 and is used for attaching chip(s) thereon. Preferably, the chip(s) may include (but is/are not limited to) die(dice) having power semiconductor device(s) or other semiconductor device(s) formed therein.

The second metal layer 105 may also comprise a second portion 127, i.e., a portion outside the dashed box 121, as can be seen better from Fig. 2. As shown in Fig. 2, the second portion 127 of the second metal layer 105 extends outwards from the first portion 125 and extends beyond the insulating material layer 103 at least on opposite first and second sides (e.g., left and right sides of the second metal layer 105 shown in Fig. 2) of the second metal layer 105. The second portion 127 of the second metal layer 105 may have at least one pair of first notches 107 extending inwards from edges, and each pair of first notches 107 is located at corresponding positions on the first and second sides of the second metal layer 105, respectively. In Figs. 1 and 2, only one pair of first notches 107 is schematically illustrated, but those skilled in the art will understand that the second portion 127 of the second metal layer 105 may include more pairs of first notches. In some embodiments, the first and second sides of the second metal layer 105 may be disposed substantially parallel to a width direction of the insulating material layer 103.

In some embodiments, projections of the at least one pair of first notches of the second metal layer 105 on a plane where the insulating material layer 103 is located do not overlap the insulating material layer 103. In other words, an inner edge of the notch 107 is outside the insulating material layer 103, so that in the top view, the insulating material layer 103 is not exposed from the notch 107, as can be seen better from Fig. 1.

Continually referring to Figs. 1 and 2, the first metal layer 101 may comprise: a first portion 115 overlapping the insulating material layer 103, as shown in the dashed box 121 of Fig. 1; and a second portion 117 extending outwards from the first portion 115 and extending beyond the insulating material layer 103 at least on opposite first and second sides (e.g., left and right sides of the first metal layer 101 as shown in Fig. 1) of the first metal layer 101. Preferably, this second portion 117 of the first metal layer 101 may have at least one pair of second notches 109 extending inwards from edges. Preferably, each pair of second notches 109 is located at corresponding positions on the first and second sides (e.g., the left and right sides of first metal layer 101 as shown in Fig. 1) of the first metal layer 101, respectively.

The at least one pair of the first notches 107 of the second metal layer 105 may be used for disposing clamping components therein. In a preferred embodiment, the at least one pair of second notches 109 in the first metal layer 101 may also be used for disposing clamping components therein to cooperate with the at least one pair of first notches 107, thereby enabling the clamping components to more firmly secure the multilayer substrate 100. At least one notch of each first notch 107 and a corresponding second notch 109 is matched with a shape of a corresponding portion of a clamping tool, so that the at least one notch can firmly engage the clamping tool. In other words, the clamping tool can engage one or both of corresponding first and second notches, which enables the multilayer substrate of the present disclosure to be clamped using a variety of clamping tools of different shapes, thereby increasing flexibility of the use.

Preferably, vertical projections of each pair of second notches 109 on the second metal layer 105 may overlap at least portions of one corresponding pair of first notches 107 of the second metal layer 105 that are used for engaging clamping tools.

Although Figs. 1 and 2 schematically show that the notches are arc-shaped (e.g., part of a circle or an ellipse), this is not intended to constitute any limitation. The notch according to the embodiments of the present disclosure may have any suitable shape which is suitable for adapting and securing the clamping component, and preferably, the shape of the notch should be configured such that the notch is suitable for the clamping component to be engage thereinto and allows for a certain error range.

In some embodiments, a width of an open edge of the first notch can be greater than that of an inner portion of the first notch in a direction parallel to the open edge, and a width of an open edge of the second notch can be greater than that of an inner portion of the second notch in a direction parallel to the open edge. In this case, the clamping tool can be engaged into the notch in a direction parallel to the multilayer substrate. Preferably, the first notch may comprise two inner edges extending inwards facing each other, and the second notch may comprise two inner edges extending inwards facing each other. Each inner edge of the first and second notches may be configured such that, with respect to an axis passing through an innermost point of the inner edge and parallel to a direction in which the notch extends inward, the inner edge has a slope gradually decreasing as the inner edge extends toward the innermost point. For example, each inner edge may have one of the following shapes: an arc which is non-continuously differentiable; and a plurality of line segments having discontinuous slopes and connected in sequence.

In some embodiments, a width of an open edge of the first notch is less than that of at least part of an inner portion of the first notch in a direction parallel to the open edge, and a width of an open edge of the second notch is less than that of at least part of an inner portion of the second notch in a direction parallel to the open edge. In this case, the clamping tool can be engaged into the notch in a direction perpendicular to the multilayer substrate.

In a preferred embodiment, the inner edge of the first notch may be arc-shaped and the inner edge of the second notch may also be arc-shaped.

In a preferred embodiment, the first notch may be part of a circle or part of an ellipse, and the second notch may also be part of a circle or part of an ellipse. For example, the notch may be half of a circle or an ellipse, may be less than half of a circle or an ellipse, or may be more than half of a circle or an ellipse.

In a preferred embodiment, the first notch may be in a shape of a trapezoid, square, rectangle, or a combination thereof, and the second notch may also be in a shape of a trapezoid, square, rectangle, or a combination thereof.

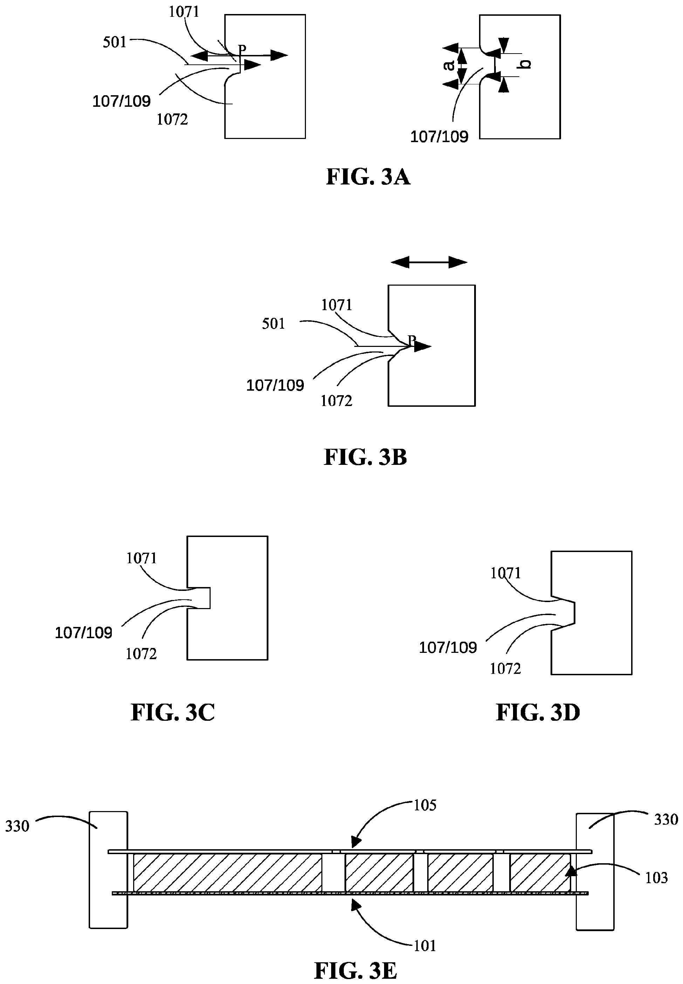

Figs. 3A-3D illustrate schematic shape diagrams of notches according to some embodiments of the present disclosure. As shown in Fig. 3A, two inner edges 1071 and 1072 of the notch 107/109 face each other and extend inwards (i.e., towards an interior of a corresponding metal layer). As shown in Fig. 3A, a width a of an open edge of the notch 107/109 may be disposed to be greater than a width b of an inner portion of the notch in a direction parallel to the open edge, as shown in a right diagram of Fig. 3A. In some embodiments, the two inner edges of the notch 107/109 extend inwards facing each other, and a distance between the two inner edges decreases gradually as they extend inwards. In other words, the distance between the two inner edges decreases gradually in a first direction (e.g. as indicated by an arrow 501 in the figure) towards the interior of the corresponding metal layer. As an example, the first direction may be a horizontal direction (X direction) in the figure; however, the present disclosure is not limited thereto.

In some embodiments, the inner edges (e.g., 1071 and 1072) of the notch 107/109 may each be configured such that, with respect to an axis passing through an innermost point (e.g., a point P) of the inner edge and parallel to a direction in which the notch extends inwards (e.g., the X-direction as shown in the figure), the inner edge has a slope (as indicated by a tangent shown by a dashed line in the figure) decreasing gradually as the inner edge extends towards the innermost point. Preferably, the shape of each inner edge may be an arc which is non-continuously differentiable. For example, the arc may include a plurality of segments connected to each other that are non-continuously differentiable therebetween.

Fig. 3B illustrates a schematic diagram of the shape of a notch according to some other embodiments of the present disclosure. As shown in Fig. 3B, a width of an open edge of the notch 107/109 may be disposed to be greater than that of an inner portion of the notch in a direction parallel to the open edge. In a preferred embodiment, a slope of the inner edge, with respect to an axis passing through an innermost point (e.g. a point P) of the inner edge and parallel to a direction in which the notch extends inwards (e.g. an X-direction as shown in the figure), decreases gradually as the inner edge extends towards the innermost point. In a preferred embodiment, each inner edge may have a plurality of line segments having discontinuous slopes and connected in sequence.

In some embodiments, the first notch of the second metal layer may be in a shape of a trapezoid, square, or rectangle, and the second notch of the first metal layer may be correspondingly in a shape of a trapezoid, square, or rectangle, as shown in Figs. 3C and 3D.

By setting the notch of the present disclosure to the shape as described above, it can bring a lot of improvements to the use of the notch. In the case where the width of the open edge of the notch is disposed to be greater than that of the inner portion of the notch in the direction parallel to the open edge, on the one hand, a distance between portions of the two inner edges of the notch that are located outermost in the notch is greater than a corresponding width of the clamping component, which makes it easy for the clamping component to find the notch and to be engaged into it; on the other hand, a distance between portions of the two inner edges that are located innermost in the notch is less than or equal to the width of the clamping component, which makes the clamping component naturally engaged at a position where the distance between the two inner edges is matched with the width of the clamping component most in the process of being engaged into the notch, thereby enabling the clamping component to clamp the multilayer substrate more firmly, and reducing or eliminating the shaking or displacement of the clamped multilayer substrate in the process of applying a molding compound. In the case where the width of the opening edge of the notch is disposed to be less than that of the inner portion of the notch in the direction parallel to the open edge, the clamping component is inserted in the notch and thus can also clamp the multilayer substrate firmly.

Fig. 3E schematically illustrates a schematic diagram of clamping the multilayer substrate 100 using positioning rods 330 as clamping components. In an encapsulation process, the multilayer substrate 100 may be secured or clamped by the positioning rods 330, so that when the molding compound (e.g., resin) is injected, the multilayer substrate 100 can be kept stable, and thus will not be displaced due to turbulence and disorderly flow of the resin. The clamping components are matched with the notches in the metal layer of the multilayer substrate, which on one hand, can avoid the use of a retract pin, thereby avoiding the formation of a blind hole in the substrate; on the other hand, can clamp the multilayer substrate more firmly, and avoid extruding the insulating material layer containing , for example, a ceramic material.

In some embodiments, the size of the first metal layer 101 in a direction (e.g., a vertical direction in the figure) different from the above-mentioned opposite first and second sides may be set to be less than that of the insulating material layer 103, and accordingly, also less than that of the second metal layer 105 in this direction, as shown in Figs. 1 and 2.

In some embodiments, the insulating material layer 103 may be integrated, e.g., the insulating material layer 103 may be one complete substrate. In other embodiments, the insulating material layer 103 may comprise a plurality of segments separated from each other. Figs. 1 and 2 exemplarily show four segments 1031, 1032, 1033, and 1034, however, the present disclosure is not limited thereto and the insulating material layer 103 may also have another number of segments. The segments are separated from each other by gaps (e.g., 1021).

In some embodiments, the first metal layer 101 may be integrated, and the second metal layer 105 may comprise a plurality of segments separated from each other, wherein each segment may comprise at least part of the first portion 125 and at least part of the second portion 127. As an example, a plurality of segments 1051, 1052, 1053, 1054, 1055, and 1057, which are separated by gaps (e.g., 1023), are shown in Figs. 1 and 2. As shown in the figure, each segment of the second metal layer 105 is attached to corresponding segment(s) of the insulating material layer 103, respectively, to provide firm and reliable fixation. In addition, the size of each segment of the second metal layer 105 may be configured based on the size of the corresponding segment(s) of the insulating material layer 103 to which it is attached.

The segments 1051, 1052, 1053, 1054 may each include at least part of the first portion 125 of the second metal layer 105 and a part extending therefrom. Respective body portions (also referred to as chip attaching portions) of the segments 1051, 1052, 1053, 1054 may be used for attaching chip(s) thereon, e.g., power chip(s), and as shown in Fig. 2, they may be the at least part of the first portion 125 of the second metal layer 105. Portions of the segments 1051, 1052, 1053, 1054 that extend from the body portions may be used for attaching leads, as also shown in Fig. 2, and thus they may be referred to as lead attaching portions.

Preferably, for a segment in a smaller size of the second metal layer 105, such as the segments 1052, 1053 and 1054 (which have a size that can accommodate only one power chip attached thereon), a body portion of this segment that has a chip attached thereon is attached to one corresponding segment of the insulating material layer 103, while a lead attaching portion that has lead(s) attached thereon is at least attached to another different corresponding segment, so that it is possible to enhance stability and further reduce effects of stress and strain. In the embodiments shown in Figs. 1 and 2, the body portions (or chip attaching portions) of the segments 1052, 1053 and 1054 are attached to the segments 1032, 1033 and 1034 of the insulating material layer 103, respectively, while their respective lead attaching portions are attached to the segment 1032 and its adjacent segment 1031, the segment 1032 and its adjacent segment 1033, and the segment 1033 and its adjacent segment 1034 of the insulating material layer 103, respectively.

Preferably, for a segment in a larger size of the second metal layer 105, such as the segment 1051 (which have a size that can accommodate a plurality of power chips attached thereon), a segment of the insulating material layer 103 that is correspondingly attached to thereto is sized to be comparable to the segment 1051. For example, the body portion (having power chip(s) attached thereon) and the lead attaching portion (having lead(s) attached thereon) of the segment 1051 both overlap the segment 1031, so that stable support is provided for the process steps of attaching the chip(s) and attaching the lead(s). However, the present disclosure is not limited thereto. In other embodiments, the segment 1051 may be attached to two or more segments of the insulating material layer according to actual requirements.

In addition, in the figure, the segments 1055 and 1057 are also shown, which have no chip disposed thereon, but are only used for providing electrical connection(s), e.g., electrical connection(s) with lead(s).

It should be understood that the segments illustrated here are merely exemplary and are not intended to constitute any limitation. In some embodiments, the second metal layer 105 may have only part of the segments shown in the figure, e.g., have only the segment 1051, or have the segments 1051 and one or more of 1052-1057; or, may have more other additional segments.

In some embodiments, the insulating material layer 103 may comprise a ceramic material, and the first metal layer 101 and the second metal layer 105 may be formed of, for example, copper (Cu) or aluminum (Al) or other suitable metal materials. For example, the insulating material layer 103 may be a ceramic substrate, and the first metal layer 101 and the second metal layers 105 may be copper layers attached on top and bottom surfaces of the ceramic substrate. Preferably, chip(s) to be attached to the first portion 125 of the second metal layer 105 is(are) power chip(s). Preferably, the multilayer substrate may be one of: a DBC substrate, an active metal braze (AMB) substrate, a direct bonding aluminum (DBA) substrate, or an insulated metal substrate.

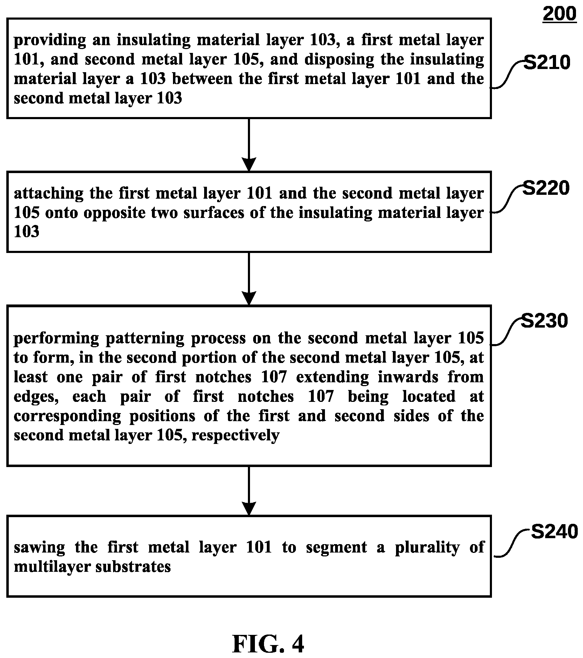

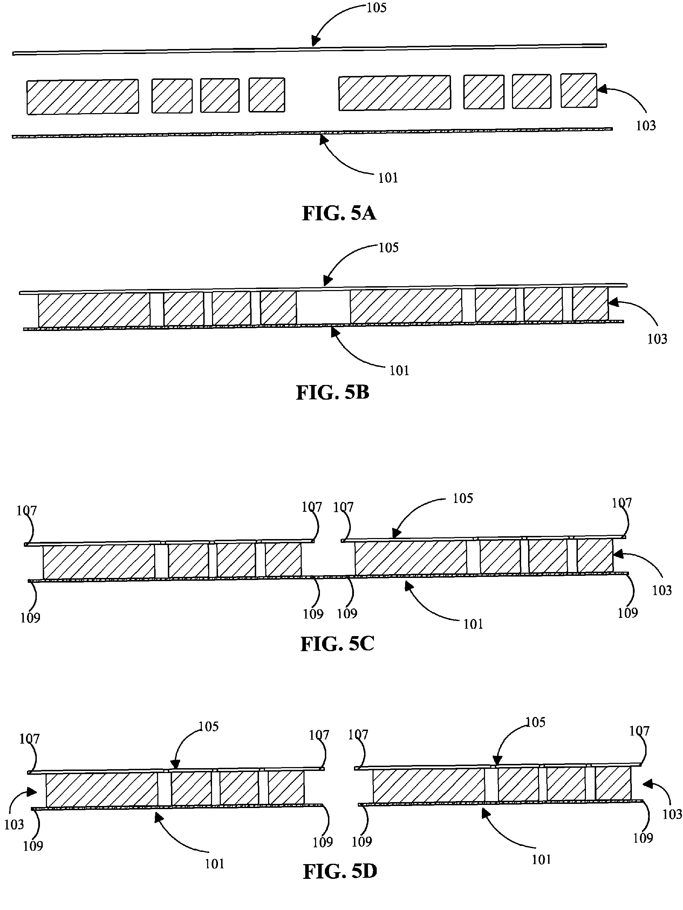

A method of manufacturing multilayer substrate(s) according to embodiments of the present disclosure is described below in conjunction with Fig. 4 and Figs. 5A to 5D. Fig. 4 illustrates an exemplary flow diagram of a method of manufacturing multilayer substrate(s) according to embodiments of the present disclosure, and Figs. 5A to 5D schematically illustrate schematic diagrams of devices corresponding to part of the steps of the method of manufacturing shown in Fig. 4. Those skilled in the art will appreciate that the method of manufacturing multilayer substrate(s) described in conjunction with Fig. 4 and Figs. 5A to 5D may be used for manufacturing the multilayer substrates (e.g., the multilayer substrate 100) according to the embodiments of the present disclosure, and thus the corresponding description of the multilayer substrates above also applies here.

As shown in Fig. 4, the method 200 of manufacturing multilayer substrate(s) according to embodiments of the present disclosure may comprise steps S210, S220, and S230.

At step S210, as shown in Fig. 5A, an insulating material layer 103, a first metal layer 101, and a second metal layer 105 are provided, and the insulating material layer 103 is disposed between the first metal layer 101 and the second metal layer 105.

In some embodiments, the first metal layer may comprise: a first portion overlapping the insulating material layer 103 and a second portion extending outwards from the first portion and extending beyond the insulating material layer 103 at least on opposite first and second sides of the first metal layer. The second metal layer 105 may comprise: a first portion overlapping the insulating material layer 103 and used for attaching chip(s) thereon, and a second portion extending outwards from the first portion and extending beyond the insulating material layer 103 at least on opposite first and second sides of the second metal layer.

At step S220, as shown in Fig. 5B, the first metal layer 101 and the second metal layer 105 are attached onto opposite two surfaces (e.g., top and bottom surfaces) of the insulating material layer 103. In preferred embodiments, the first metal layer 101 and the second metal layer 105 may be attached onto the opposite two surfaces (e.g., the top and bottom surfaces) of the insulating material layer 103 by sintering, brazing, soldering, or curing.

At step S230, as shown in Fig. 5C, patterning process is performed on the second metal layer 105 to form, in the second portion of the second metal layer 105, at least one pair of first notches 107 extending inwards from edges. Each pair of first notches 107 is located at corresponding positions of the first and second sides of the second metal layer 105, respectively. Preferably, projections of the at least one pair of first notches 107 on a plane where the insulating material layer 103 is located do not overlap the insulating material layer 103.

At step S240, as shown in Fig. 5D, the first metal layer 101 is sawed to segment a plurality of multilayer substrates.

In some embodiments, the method 200 of manufacturing multilayer substrate(s) may further comprise: performing patterning process on the first metal layer 101 to form, in the second portion of the first metal layer 101, at least one pair of second notches 109 extending inwards from edges. Each pair of second notches 109 is located at corresponding positions of the first and second sides of the first metal layer 101, respectively. At least one notch of each first notch 107 and a corresponding second notch 109 is matched with a shape of a corresponding portion of a clamping tool, so that the at least one notch can firmly engage the clamping tool. In other words, the clamping tool can engage either or both of corresponding first and second notches, which enables the multilayer substrates of the present disclosure to be clamped using a variety of clamping tools of different shapes, thereby increasing flexibility of the use.

Preferably, vertical projections of each pair of second notches 109 on the second metal layer 105 may at least overlap portions of one corresponding pair of first notches 107 of the second metal layer 105 that are used for engaging the clamping tools.

In some embodiments, a width of an open edge of the first notch can be greater than that of an inner portion of the first notch in a direction parallel to the open edge, and a width of an open edge of the second notch can be greater than that of an inner portion of the second notch in a direction parallel to the open edge. In this case, the clamping tool can be engaged into the notch in a direction parallel to the multilayer substrate. Preferably, the first notch may comprise two inner edges extending inwards facing each other, and the second notch may comprise two inner edges extending inwards facing each other. Each inner edge of the first and second notches may be configured such that, with respect to an axis passing through an innermost point of the inner edge and parallel to a direction in which the notch extends inward, the inner edge has a slope gradually decreasing as the inner edge extends toward the innermost point. For example, each inner edge may have one of the following shapes: an arc which is non-continuously differentiable; and a plurality of line segments having discontinuous slopes and connected in sequence.

In some embodiments, a width of an open edge of the first notch is less than that of at least part of the inner portion of the first notch in a direction parallel to the open edge, and a width of an open edge of the second notch is less than that of at least part of the inner portion of the second notch in a direction parallel to the open edge. In this case, the clamping tool can be engaged into the notch in a direction perpendicular to the multilayer substrate.

In a preferred embodiment, the inner edge of the first notch may be arc-shaped and the inner edge of the second notch may also be arc-shaped.

In a preferred embodiment, the first notch may be part of a circle or part of an ellipse, and the second notch may also be part of a circle or part of an ellipse. For example, the notch may be half of a circle or an ellipse, may be less than half of a circle or an ellipse, or may be more than half of a circle or an ellipse.

In a preferred embodiment, the first notch may be in a shape of a trapezoid, square, rectangle or a combination thereof, and the second notch may also be in a shape of a trapezoid, square, rectangle or a combination thereof.

In some embodiments, the method 200 of manufacturing multilayer substrate(s) may further comprise: before attaching the first metal layer 101 and the second metal layer 105 to the insulating material layer 103, performing segmenting process on the insulating material layer 103 to segment the insulating material layer 103 into a plurality of segments separated from each other.

In some embodiments, the first metal layer 101 is integrated.

In some embodiments, the performing patterning process on the second metal layer 105 may further comprise: patterning the second metal layer 105 such that it comprise a plurality of segments separated from each other. Preferably, each segment of the second metal layer 105 may comprise at least part of the first portion and at least part of the second portion, and they are attached to corresponding segment(s) of the insulating material layer 103, respectively.

In some embodiments, the insulating material layer 103 may be a ceramic substrate, the first metal layer 101 and the second metal layer 105 may be copper layers, and chip(s) to be attached to the second metal layer may be power chip(s).

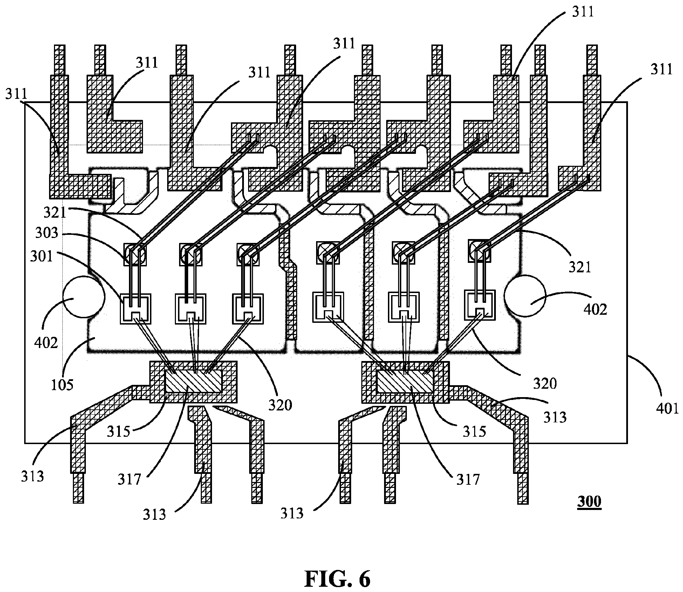

Fig. 6 illustrates a schematic diagram of a power module 300 according to some embodiments of the present disclosure. As shown in Fig. 6, the power module 300 may comprise the multilayer substrate according to any embodiment of the present disclosure, to which the above description related to the multilayer substrate 100 may apply. The power module 300 may further comprise chip(s) 301 and/or 303, and the chip(s) 301 may be, for example, but not limited to, power chip(s) comprising power semiconductor device(s). Optionally, the chip(s) 303 may also be collaborative chip(s) that comprise(s) device(s) (e.g., a diode) that cooperate(s) with power device(s). The chip(s) may be attached to the first portion of the second metal layer 105 of the multilayer substrate.

The power module 300 may also comprise a lead frame. As shown in Fig. 6, the lead frame may include one or more leads, for example, lead(s) 311 attached (and thus electrically connected) to the second metal layer 105. Preferably, the lead frame may also include lead(s) 313 and chip attaching area(s) 315, for attaching, for example, control die(dice) 317. As an example, two chip attaching areas 315 and two control dies 317 are shown in the figure.

The power chip(s) 301 and the collaborative chip(s) 303 may be electrically connected by wire(s) 321, and electrically connected to the corresponding lead(s) 311. The control die(s) 317 may be attached to the power chip(s) 301 by wire(s) 320, and attached to the lead(s) 313 by wire(s) (not shown). The leads 311 and 313 may be electrically connected to the outside or to other components of the module.

The power module 300 may further comprise a molding compound 401, which at least encapsulates at least part of the multilayer substrate, the chip(s), and at least part of the lead frame, and leaves a surface of the first metal layer of the multilayer substrate that is far away from the chip(s) exposed, for the purpose of for example, heat dissipation. The molding compound has therein disposed at least one pair of circular holes 402. At least part of vertical projections of the at least one pair of circular holes 402 on the second metal layer overlap one corresponding pair of first notches of the second metal layer, and the at least one pair of circular holes 402 are usable for mounting screws.

By using the multilayer substrate or the power module according to the embodiments of the present disclosure, it is possible to form, in the power module (particularly in a housing of the molding compound), circular holes located on the outside of the multilayer substrate and usable for mounting screws, while avoiding a blind hole caused by a retract pin. When the packaged power module is further mounted, screw fixation can be performed directly using the circular holes, thereby effectively improving the fixation effect and the mounting efficiency of the power module.

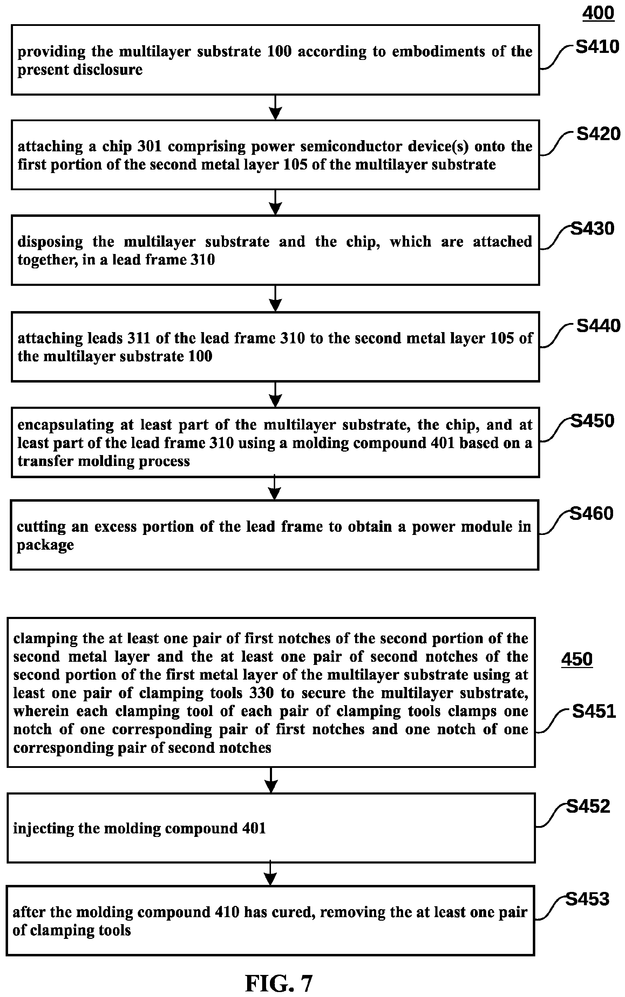

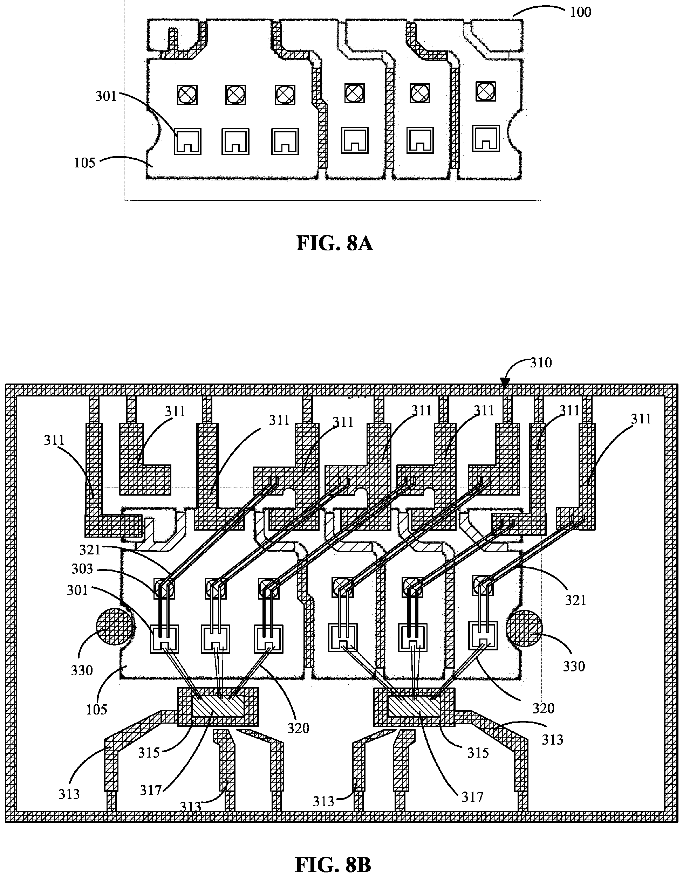

A method of manufacturing a power module according to embodiments of the present disclosure is described below in conjunction with Figs. 7 and 8A to 8C. Fig. 7 illustrates an exemplary flow diagram of a method of manufacturing a power module according to embodiments of the present disclosure, and Figs. 8A to 8C schematically illustrate schematic diagrams of devices corresponding to part of the steps of the method shown in Fig. 7. Those skilled in the art will appreciate that the method of manufacturing a power module described in conjunction with Figs. 7 and 8A to 8C may be used for manufacturing the power module (e.g., the power module 300) according to the embodiments of the present disclosure, and thus the corresponding description of the power modules above also applies here.

As shown in Fig. 7, the method 400 of manufacturing a power module according to the embodiments of the present disclosure may comprise steps S410, S420, S430, S440, S450, and S460.

At step S410, as shown in Fig. 8A, the multilayer substrate 100 according to the embodiments of the present disclosure is provided.

At step S420, a chip 301 comprising power semiconductor device(s) is attached onto the first portion of the second metal layer 105 of the multilayer substrate.

At step S430, as shown in Fig. 8B, the multilayer substrate and the chip which are attached together are disposed in the lead frame 310.

At step S440, continually referring to Fig. 8B, lead(s) 311 of the lead frame 310 is (are) attached to the second metal layer 105 of the multilayer substrate 100.

Preferably, the method may further comprise performing corresponding interconnections on the respective components, including, for example: attaching, for example, control die(s) 317 by the chip attaching area(s) 315 and lead(s) 313 of the lead frame 310; electrically connecting power chip(s) 301 and cooperative chip(s) (s) 303 by wire(s) 321, and electrically connecting them to corresponding lead(s) 311; attaching the control die(s) 317 to the power chip(s) 301 by wire(s) 320, and/or attaching the control die(s) 317 to the lead(s) 313 by wire (s) (not shown). The leads 311 and 313 may be electrically connected to the outside or to other components of the module.

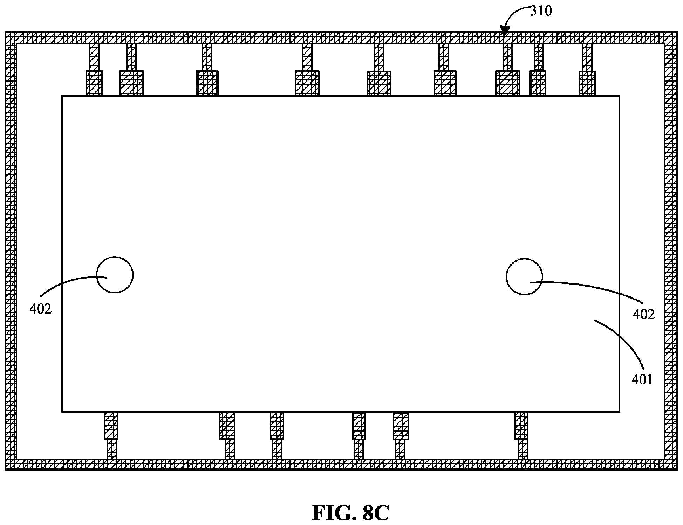

At step S450, as shown in Fig. 8C, at least part of the multilayer substrate, the chip, and at least part of the lead frame 310 are encapsulated using a molding compound 401 based on a transfer molding process. Preferably, the molding compound leaves a surface of the first metal layer of the multilayer substrate that is far away from the chip exposed.

At step S460, an excess portion of the lead frame is cut to obtain a power module in package, which is shown in Fig. 6.

In some embodiments according to the present disclosure, the step S450 of encapsulating at least part of the multilayer substrate, the chip, and at least part of the lead frame using a molding compound based on a transfer molding process may be implemented by steps S4351, S452, and S453 described below.

At step S451, as shown in Fig. 8B, the at least one pair of first notches of the second portion of the second metal layer and the at least one pair of second notches of the second portion of the first metal layer of the multilayer substrate are clamped using at least one pair of clamping tools (e.g., positioning rods 330) to secure the multilayer substrate. Each clamping tool of each pair of clamping tools clamps one notch of one corresponding pair of first notches and one notch of one corresponding pair of second notches.

At step S452, the molding compound 401 is injected.

At step S453, after the molding compound 401 has cured, the at least one pair of clamping tools are removed. The removing the at least one pair of clamping tools may leave at least one pair of circular holes 402 in the molding compound 401. At least part of vertical projections of each pair of circular holes 402 on the second metal layer overlap one corresponding pair of first notches of the second metal layer, and each pair of circular holes 402 are usable for mounting screws.

The present disclosure also conceptualizes an electrical system, which may include the power module according to any embodiment of the present disclosure. As an example, the electrical system may include, for example, an inverter, a new energy vehicle, a wind power system, a solar power system, an energy storage system, or any other device or system that requires the application of the power module of the present disclosure.

As used herein, a term "chip" includes, but is not limited to a die. A term "overlap" means at least partial overlap unless a different meaning is clearly indicated in the context.

Terms "front", "back", "top", "bottom", "above", "below", and the like in the description and the claims, if any, are used for descriptive purposes and not necessarily for describing permanent relative positions. It should be understood that the terms so used are interchangeable where appropriate such that the embodiments of the present disclosure described herein, for example, can operate in other orientations different from those illustrated herein or otherwise described.

As used herein, a term "exemplary" means "serving as an example, instance, or illustration", and not as a "model" that is to be reproduced exactly. Any implementation exemplarily described herein is not necessarily to be construed as preferred or advantageous over other implementations. Furthermore, the present disclosure is not limited by any expressed or implied theory presented in the above TECHNICAL FIELD, BACKGROUND, SUMMARY, or DETAILED DESCRIPTION.

As used herein, a term "substantially" means encompassing any minor variations caused by imperfections in design or manufacturing, tolerances of components or elements, environmental effects and/or other factors. The term "substantially" also allows for differences from a perfect or ideal situation caused by parasitic effect, noise, and other practical considerations that may exist in a practical implementation.

In addition, the foregoing description may mention elements or nodes or features that are "connected" or "coupled" together. As used herein, unless expressly stated otherwise, "connected" means that one element/node/feature is directly connected with (or directly communicates with) another element/node/feature in an electrical, mechanical, logical, or other manner. Similarly, unless expressly stated otherwise, "coupled" means that one element/node/feature may be directly or indirectly connected with another element/node/feature in a mechanical, electrical, logical or other manner, to allow interaction, even if the two elements are not directly connected. That is, "coupled" is intended to include direct and indirect connections of elements or other features, including connection using one or more intermediate elements.

In addition, for reference purposes only, similar terms such as "first" and "second" can also be used herein, and thus are not intended to be limiting. For example, unless clearly indicated by the context, the terms "first", "second" and other such numerical terms involving structures or elements do not imply a sequence or order.

It should be further understood that a term "comprise/include", when used herein, specifies the presence of stated features, wholes, steps, operations, units, and/or components, but does not preclude the presence or addition of one or more other features, wholes, steps, operations, units, components, and/or combinations thereof.

In the present disclosure, a term "provide" is used broadly to encompass all ways of obtaining an object, and thus "providing an object" includes, but is not limited to, "purchasing", "preparing/manufacturing", "arranging/setting", "installing/assembling", and/or "ordering" the object, and so on.

## Claims

1. A multilayer substrate, comprising:
an insulating material layer (103);
a first metal layer (101) attached to the insulating material layer (103) on one surface of the insulating material layer (103) and
a second metal layer (105) attached to the insulating material layer (103) on another opposite surface of the insulating material layer (103), wherein the second metal layer (105) comprises:
a first portion (125) overlapping the insulating material layer (103) and used for attaching one or more chips thereon; and
a second portion (127) extending outwards from the first portion (125) and extending beyond the insulating material layer (103) at least on opposite first and second sides of the second metal layer (105), wherein the second portion (127) has at least one pair of first notches (107) extending inwards from edges, and each pair of first notches (107) are located at corresponding positions on the first and second sides of the second metal layer (105) respectively, and wherein the first metal layer comprises:
a first portion (115) overlapping the insulating material layer (103); and
a second portion (117) extending outwards from the first portion (115) and extending beyond the insulating material layer (103) at least on opposite first and second sides of the first metal layer (101), the second portion (117) having at least one pair of second notches (109) extending inwards from edges.

2. The multilayer substrate according to claim 1, wherein each pair of second notches are located at corresponding positions of the first and second sides of the first metal layer, respectively; and
wherein at least one notch of each first notch and a corresponding second notch is matched with a shape of a corresponding portion of a clamping tool, so that the at least one notch is capable of firmly engaging the clamping tool.

3. The multilayer substrate according to claim 2, wherein vertical projections of each pair of second notches on the second metal layer overlap at least portions of one corresponding pair of first notches of the second metal layer that are used for engaging clamping tools.

4. The multilayer substrate according to claim **2,** wherein:
a width of an open edge of the first notch is greater than that of an inner portion of the first notch in a direction parallel to the open edge; and
a width of an open edge of the second notch is greater than that of an inner portion of the second notch in a direction parallel to the open edge.

5. The multilayer substrate according to claim **2,** wherein:
a width of an open edge of the first notch is less than that of at least part of an inner portion of the first notch in a direction parallel to the open edge; and
a width of an open edge of the second notch is less than that of at least part of an inner portion of the second notch in a direction parallel to the open edge.

6. The multilayer substrate according to claim 4, wherein:
the first notch comprises two inner edges extending inward facing each other;
the second notch comprises two inner edges extending inward facing each other; and
each inner edge of the first notch and the second notch is configured such that, with respect to an axis passing through an innermost point of the inner edge and parallel to a direction in which the respective notch extends inward, the inner edge has a slope gradually decreasing as the inner edge extends toward the innermost point.

7. The multilayer substrate according to claim 6, wherein each inner edge has one of the following shapes:
an arc which is non-continuously differentiable; and
a plurality of line segments having discontinuous slopes and connected in sequence.

8. The multilayer substrate according to claim 2, wherein:
the inner edge of the first notch is arc-shaped; and
the inner edge of the second notch is arc-shaped.

9. The multilayer substrate according to claim 2, wherein:
the first notch is part of a circle or part of an ellipse, and the second notch is part of a circle or part of an ellipse; or
the first notch is in a shape of a trapezoid, square, rectangle, or a combination thereof, and the second notch is in a shape of a trapezoid, square, rectangle, or a combination thereof.

10. The multilayer substrate according to claim 1, wherein projections of the at least one pair of first notches on a plane where the insulating material layer is located do not overlap the insulating material layer.

11. The multilayer substrate according to claim 1, wherein:
the insulating material layer comprises a plurality of segments separated from each other;
the first metal layer is integrated;
the second metal layer comprises a plurality of segments separated from each other, each segment comprising at least part of the first portion and at least part of the second portion; and
the segments of the second metal layer are attached to corresponding segments of the insulating material layer, respectively.

12. A method of manufacturing one or more multilayer substrates, comprising:
providing an insulating material layer (103), a first metal layer (101) and a second metal layer (105), and disposing the insulating material layer (103) between the first metal layer (101) and the second metal layer (105), wherein:
the first metal layer (101) comprises: a first portion (115) overlapping the insulating material layer (103), and a second portion (117) extending outwards from the first portion (115) and extending beyond the insulating material layer (103) at least on opposite first and second sides of the first metal layer (101), and the second metal layer (105) comprises: a first portion (125) overlapping the insulating material layer (103) and used for attaching one or more chips thereon, and a second portion (127) extending outwards from the first portion (125) and extending beyond the insulating material layer (103) at least on opposite first and second sides of the second metal layer (105); a
attaching the first and second metal layers (101; 105) onto opposite two surfaces of the insulating material layer (103);
performing patterning process on the second metal layer (105) to form, in the second portion of the second metal layer (105), at least one pair of first notches (107) extending inwards from edges, each pair of first notches (107) being located at corresponding positions of the first and second sides of the second metal layer (105), respectively;
performing patterning process on the first metal layer (101) to form, in the second portion (117) of the first metal layer (101), at least one pair of second notches (109) extending inwards from edges;
wherein each pair of second notches (109) are located at corresponding positions of the first and second sides of the first metal layer (101), respectively; and
sawing the first metal layer (101) to segment a plurality of multilayer substrates.

13. The method of manufacturing according to claim 12, wherein the patterning of the first layer is performed so that at least one notch of each first notch and a corresponding second notch is matched with a shape of a corresponding portion of a clamping tool, so that the at least one notch is capable of firmly engaging the clamping tool.

14. The method of manufacturing according to claim 13, wherein vertical projections of each pair of second notches on the second metal layer overlap at least portions of one corresponding pair of first notches of the second metal layer that are used for engaging clamping tools.

15. The method of manufacturing according to claim 13, wherein:
a width of an open edge of the first notch is greater than that of an inner portion of the first notch in a direction parallel to the open edge; and
a width of an open edge of the second notch is greater than that of an inner portion of the second notch in a direction parallel to the open edge.

16. The method of manufacturing according to claim 13, wherein:
a width of an open edge of the first notch is less than that of at least part of an inner portion of the first notch in a direction parallel to the open edge; and
a width of an open edge of the second notch is less than that of at least part of an inner portion of the second notch in a direction parallel to the open edge.

17. The method of manufacturing according to claim 15, wherein:
the first notch comprises two inner edges extending inward facing each other;
the second notch comprises two inner edges extending inward facing each other; and
each inner edge of the first notch and the second notch is configured such that, with respect to an axis passing through an innermost point of the inner edge and parallel to a direction in which the respective notch extends inward, the inner edge has a slope gradually decreasing as the inner edge extends toward the innermost point.

18. The method of manufacturing according to claim 17, wherein each inner edge has one of the following shapes:
an arc which is non-continuously differentiable; and
a plurality of line segments having discontinuous slopes and connected in sequence.

19. The method of manufacturing according to claim 13, wherein:
the inner edge of the first notch is arc-shaped; and
the inner edge of the second notch is arc-shaped.

20. A power module, comprising:
(i) a multilayer substrate according to any of claims 1 to 11,
(ii) a chip comprising one or more power semiconductor devices;
wherein the chip is attached to the first portion of the second metal layer of the multilayer substrate.

## Patentansprüche

1. Mehrschichtiges Substrat, umfassend:
eine Isoliermaterialschicht (103);
eine erste Metallschicht (101), die an der Isoliermaterialschicht (103) an einer Oberfläche der Isoliermaterialschicht (103) befestigt ist, und
eine zweite Metallschicht (105), die an der Isoliermaterialschicht (103) auf einer anderen gegenüberliegenden Oberfläche der Isoliermaterialschicht (103) befestigt ist,
wobei die zweite Metallschicht (105) umfasst:
einen ersten Abschnitt (125), der die Isoliermaterialschicht (103) überlappt und zum Befestigen eines oder mehrerer Chips daran verwendet wird; und
einen zweiten Abschnitt (127), der sich von dem ersten Abschnitt (125) nach außen erstreckt und sich mindestens an gegenüberliegenden ersten und zweiten Seiten der zweiten Metallschicht (105) über die Isoliermaterialschicht (103) hinaus erstreckt,
wobei der zweite Abschnitt (127) mindestens ein Paar erster Kerben (107) aufweist, die sich von Kanten nach innen erstrecken, und jedes Paar erster Kerben (107) sich an entsprechenden Positionen auf der ersten und zweiten Seite der zweiten Metallschicht (105) befindet, und wobei die erste Metallschicht umfasst:
einen ersten Abschnitt (115), der die Isoliermaterialschicht (103) überlappt; und
einen zweiten Abschnitt (117), der sich von dem ersten Abschnitt (115) nach außen erstreckt und sich mindestens an gegenüberliegenden ersten und zweiten Seiten der ersten Metallschicht (101) über die Isoliermaterialschicht (103) hinaus erstreckt, wobei der zweite Abschnitt (117) mindestens ein Paar zweiter Kerben (109) aufweist, die sich von Kanten nach innen erstrecken.

2. Mehrschichtiges Substrat nach Anspruch 1, wobei sich jedes Paar zweiter Kerben an entsprechenden Positionen der ersten bzw. zweiten Seite der ersten Metallschicht befindet; und
wobei mindestens eine Kerbe jeder ersten Kerbe und einer entsprechenden zweiten Kerbe mit einer Form eines entsprechenden Abschnitts eines Spannwerkzeugs übereinstimmt, sodass die mindestens eine Kerbe in der Lage ist, das Spannwerkzeug fest einzurasten.

3. Mehrschichtiges Substrat nach Anspruch 2, wobei vertikale Vorsprünge jedes Paars zweiter Kerben auf der zweiten Metallschicht mindestens Abschnitte eines entsprechenden Paars erster Kerben der zweiten Metallschicht überlappen, die zum Einrasten von Spannwerkzeugen verwendet werden.

4. Mehrschichtiges Substrat nach Anspruch 2, wobei:
eine Breite einer offenen Kante der ersten Kerbe größer ist als die eines inneren Abschnitts der ersten Kerbe in einer Richtung parallel zur offenen Kante; und
eine Breite einer offenen Kante der zweiten Kerbe größer ist als die eines inneren Abschnitts der zweiten Kerbe in einer Richtung parallel zur offenen Kante.

5. Mehrschichtiges Substrat nach Anspruch 2, wobei:
eine Breite einer offenen Kante der ersten Kerbe kleiner ist als die mindestens eines Teils eines inneren Abschnitts der ersten Kerbe in einer Richtung parallel zur offenen Kante; und
eine Breite einer offenen Kante der zweiten Kerbe kleiner ist als die mindestens eines Teils eines inneren Abschnitts der zweiten Kerbe in einer Richtung parallel zur offenen Kante.

6. Mehrschichtiges Substrat nach Anspruch 4, wobei:
die erste Kerbe zwei innere Kanten umfasst, die sich einander zugewandt nach innen erstrecken;
die zweite Kerbe zwei innere Kanten umfasst, die sich einander zugewandt nach innen erstrecken; und
jede innere Kante der ersten Kerbe und der zweiten Kerbe so eingerichtet ist, dass in Bezug auf eine Achse, die durch einen innersten Punkt der inneren Kante und parallel zu einer Richtung verläuft, in die sich die jeweilige Kerbe nach innen erstreckt, die innere Kante eine allmählich abnehmende Neigung aufweist, wenn sich die innere Kante zu dem innersten Punkt erstreckt.

7. Mehrschichtiges Substrat nach Anspruch 6, wobei jede innere Kante eine der folgenden Formen aufweist:
einen Bogen, der nicht durchgehend differenzierbar ist; und
eine Vielzahl von Liniensegmenten, die diskontinuierliche Neigungen aufweisen und in Sequenz verbunden sind.

8. Mehrschichtiges Substrat nach Anspruch 2, wobei:
die innere Kante der ersten Kerbe bogenförmig ist; und
die innere Kante der zweiten Kerbe bogenförmig ist.

9. Mehrschichtiges Substrat nach Anspruch 2, wobei:
die erste Kerbe Teil eines Kreises oder Teil einer Ellipse ist, und die zweite Kerbe Teil eines Kreises oder Teil einer Ellipse ist; oder
die erste Kerbe die Form eines Trapez, Quadrats, Rechtecks oder eine Kombination davon hat, und die zweite Kerbe die Form eines Trapez, Quadrats, Rechtecks oder eine Kombination davon hat.

10. Mehrschichtiges Substrat nach Anspruch 1, wobei Vorsprünge des mindestens einen Paars erster Kerben auf einer Ebene, in der sich die Isoliermaterialschicht befindet, die Isoliermaterialschicht nicht überlappen.

11. Mehrschichtiges Substrat nach Anspruch 1, wobei:
die Isoliermaterialschicht eine Vielzahl von voneinander getrennten Segmenten umfasst;
die erste Metallschicht integriert ist;
die zweite Metallschicht eine Vielzahl von voneinander getrennten Segmenten umfasst, wobei jedes Segment mindestens einen Teil des ersten Abschnitts und mindestens einen Teil des zweiten Abschnitts umfasst; und
die Segmente der zweiten Metallschicht jeweils an entsprechenden Segmenten der Isoliermaterialschicht befestigt sind.

12. Verfahren zur Herstellung eines oder mehrerer mehrschichtiger Substrate, umfassend:
Bereitstellen einer Isoliermaterialschicht (103), einer ersten Metallschicht (101) und
einer zweiten Metallschicht (105), und Anordnen der Isoliermaterialschicht (103) zwischen der ersten Metallschicht (101) und der zweiten Metallschicht (105), wobei:
die erste Metallschicht (101) umfasst: einen ersten Abschnitt (115), der die Isoliermaterialschicht (103) überlappt, und einen zweiten Abschnitt (117), der sich von dem ersten Abschnitt (115) nach außen erstreckt und sich mindestens an gegenüberliegenden ersten und zweiten Seiten der ersten Metallschicht (101) über die Isoliermaterialschicht (103) hinaus erstreckt, und die zweite Metallschicht (105) umfasst: einen ersten Abschnitt (125), der die Isoliermaterialschicht (103) überlappt und zum Befestigen eines oder mehrerer Chips daran verwendet wird, und einen zweiten Abschnitt (127), der sich von dem ersten Abschnitt (125) nach außen erstreckt und sich mindestens auf gegenüberliegenden ersten und zweiten Seiten der zweiten Metallschicht (105) über die Isoliermaterialschicht (103) hinaus erstreckt;
Befestigen der ersten und der zweiten Metallschicht (101; 105) auf zwei gegenüberliegenden Oberflächen der Isoliermaterialschicht (103);
Durchführen eines Strukturierungsprozesses auf der zweiten Metallschicht (105), um in dem zweiten Abschnitt der zweiten Metallschicht (105) mindestens ein Paar erster Kerben (107) zu bilden, die sich von den Kanten nach innen erstrecken, wobei sich jedes Paar erster Kerben (107) an entsprechenden Positionen der ersten und der zweiten Seite der zweiten Metallschicht (105) befindet;
Durchführen eines Strukturierungsprozesses auf der ersten Metallschicht (101), um in dem zweiten Abschnitt (117) der ersten Metallschicht (101) mindestens ein Paar zweiter Kerben (109) zu bilden, die sich von den Kanten nach innen erstrecken;
wobei sich jedes Paar zweiter Kerben (109) an entsprechenden Positionen der ersten und der zweiten Seite der ersten Metallschicht (101) befindet; und
Sägen der ersten Metallschicht (101), um eine Vielzahl von mehrschichtigen Substraten zu segmentieren.

13. Herstellungsverfahren nach Anspruch 12, wobei das Strukturieren der ersten Schicht so durchgeführt wird, dass mindestens eine Kerbe jeder ersten Kerbe und einer entsprechenden zweiten Kerbe mit einer Form eines entsprechenden Abschnitts eines Spannwerkzeugs übereinstimmt, sodass die mindestens eine Kerbe in der Lage ist, das Spannwerkzeug fest einzurasten.

14. Herstellungsverfahren nach Anspruch 13, wobei vertikale Vorsprünge jedes Paars zweiter Kerben auf der zweiten Metallschicht mindestens Abschnitte eines entsprechenden Paars erster Kerben der zweiten Metallschicht überlappen, die zum Einrasten von Spannwerkzeugen verwendet werden.

15. Herstellungsverfahren nach Anspruch 13, wobei:
eine Breite einer offenen Kante der ersten Kerbe größer ist als die eines inneren Abschnitts der ersten Kerbe in einer Richtung parallel zur offenen Kante; und
eine Breite einer offenen Kante der zweiten Kerbe größer ist als die eines inneren Abschnitts der zweiten Kerbe in einer Richtung parallel zur offenen Kante.

16. Herstellungsverfahren nach Anspruch 13, wobei:
eine Breite einer offenen Kante der ersten Kerbe kleiner ist als die mindestens eines Teils eines inneren Abschnitts der ersten Kerbe in einer Richtung parallel zur offenen Kante; und
eine Breite einer offenen Kante der zweiten Kerbe kleiner ist als die mindestens eines Teils eines inneren Abschnitts der zweiten Kerbe in einer Richtung parallel zur offenen Kante.

17. Herstellungsverfahren nach Anspruch 15, wobei:
die erste Kerbe zwei innere Kanten umfasst, die sich einander zugewandt nach innen erstrecken;
die zweite Kerbe zwei innere Kanten umfasst, die sich einander zugewandt nach innen erstrecken; und
jede innere Kante der ersten Kerbe und der zweiten Kerbe so eingerichtet ist, dass in Bezug auf eine Achse, die durch einen innersten Punkt der inneren Kante und parallel zu einer Richtung verläuft, in die sich die jeweilige Kerbe nach innen erstreckt, die innere Kante eine allmählich abnehmende Neigung aufweist, wenn sich die innere Kante zu dem innersten Punkt erstreckt.

18. Herstellungsverfahren nach Anspruch 17, wobei jede innere Kante eine der folgenden Formen aufweist:
einen Bogen, der nicht kontinuierlich unterschieden werden kann; und
eine Vielzahl von Liniensegmenten, die diskontinuierliche Neigungen aufweisen und in Sequenz verbunden sind.

19. Herstellungsverfahren nach Anspruch 13, wobei:
die innere Kante der ersten Kerbe bogenförmig ist; und
die innere Kante der zweiten Kerbe bogenförmig ist.

20. Leistungsmodul, umfassend:
(i) ein mehrschichtiges Substrat nach einem der Ansprüche 1 bis 11,
(ii) einen Chip, der eine oder mehrere Leistungshalbleitervorrichtungen umfasst;
wobei der Chip an dem ersten Abschnitt der zweiten Metallschicht des mehrschichtigen Substrats befestigt ist.

## Revendications

1. Substrat multicouche, comprenant :
une couche de matériau isolant (103) ;
une première couche métallique (101) fixée à la couche de matériau isolant (103) sur une surface de la couche de matériau isolant (103) et
une seconde couche métallique (105) fixée à la couche de matériau isolant (103) sur une autre surface opposée de la couche de matériau isolant (103),
dans lequel la seconde couche métallique (105) comprend :
une première partie (125) chevauchant la couche de matériau isolant (103) et destinée à la fixation d'une ou plusieurs puces sur celle-ci ; et
une seconde partie (127) s'étendant vers l'extérieur à partir de la première partie (125) et s'étendant au-delà de la couche de matériau isolant (103) au moins sur des premier et second côtés opposés de la seconde couche métallique (105),
dans lequel la seconde partie (127) présente au moins une paire de premières encoches (107) s'étendant vers l'intérieur à partir de bords, et chaque paire de premières encoches (107) est située en des positions correspondantes sur les premier et second côtés de la seconde couche métallique (105) respectivement, et dans lequel la première couche métallique comprend :
une première partie (115) chevauchant la couche de matériau isolant (103) ; et
une seconde partie (117) s'étendant vers l'extérieur à partir de la première partie (115) et s'étendant au-delà de la couche de matériau isolant (103) au moins sur des premier et second côtés opposés de la première couche métallique (101), la seconde partie (117) présentant au moins une paire de secondes encoches (109) s'étendant vers l'intérieur à partir de bords.

2. Substrat multicouche selon la revendication 1, dans lequel chaque paire de secondes encoches est située en des positions correspondantes des premier et second côtés de la première couche métallique, respectivement ; et
dans lequel au moins une encoche parmi chaque première encoche et une seconde encoche correspondante est adaptée à une forme d'une partie correspondante d'un outil de serrage, de sorte que l'au moins une encoche soit apte à venir solidement en prise avec l'outil de serrage.

3. Substrat multicouche selon la revendication 2, dans lequel des saillies verticales de chaque paire de secondes encoches sur la seconde couche métallique chevauchent au moins des parties d'une paire correspondante de premières encoches de la seconde couche métallique qui sont destinées à venir en prise avec des outils de serrage.

4. Substrat multicouche selon la revendication 2, dans lequel :
une largeur d'un bord ouvert de la première encoche est supérieure à celle d'une partie interne de la première encoche dans une direction parallèle au bord ouvert ; et
une largeur d'un bord ouvert de la seconde encoche est supérieure à celle d'une partie interne de la seconde encoche dans une direction parallèle au bord ouvert.

5. Substrat multicouche selon la revendication 2, dans lequel :
une largeur d'un bord ouvert de la première encoche est inférieure à celle d'au moins une partie d'une partie interne de la première encoche dans une direction parallèle au bord ouvert ; et
une largeur d'un bord ouvert de la seconde encoche est inférieure à celle d'au moins une partie d'une partie interne de la seconde encoche dans une direction parallèle au bord ouvert.

6. Substrat multicouche selon la revendication 4, dans lequel :
la première encoche comprend deux bords intérieurs s'étendant vers l'intérieur et en regard l'un de l'autre ;
la seconde encoche comprend deux bords intérieurs s'étendant vers l'intérieur et en regard l'un de l'autre ; et
chaque bord intérieur de la première encoche et de la seconde encoche est configuré de sorte que, par rapport à un axe traversant un point le plus intérieur du bord intérieur et parallèle à une direction dans laquelle l'encoche respective s'étend vers l'intérieur, le bord intérieur présente une pente progressivement décroissante au fur et à mesure que le bord intérieur s'étend vers le point le plus intérieur.

7. Substrat multicouche selon la revendication 6, dans lequel chaque bord intérieur présente l'une des formes suivantes :
un arc qui est non-continument différentiable ; et
une pluralité de segments linéaires présentant des pentes discontinues et reliés en séquence.

8. Substrat multicouche selon la revendication 2, dans lequel :
le bord intérieur de la première encoche est arqué ; et
le bord intérieur de la seconde encoche est arqué.

9. Substrat multicouche selon la revendication 2, dans lequel :
la première encoche fait partie d'un cercle ou partie d'une ellipse, et la seconde encoche fait partie d'un cercle ou partie d'une ellipse ; ou
la première encoche est en forme de trapèze, de carré, de rectangle ou d'une combinaison de ceux-ci, et la seconde encoche est en forme de trapèze, de carré, de rectangle ou d'une combinaison de ceux-ci.

10. Substrat multicouche selon la revendication 1, dans lequel les saillies de l'au moins une paire de premières encoches sur un plan où se trouve la couche de matériau isolant ne chevauchent pas la couche de matériau isolant.

11. Substrat multicouche selon la revendication 1, dans lequel :
la couche de matériau isolant comprend une pluralité de segments séparés les uns des autres ;
la première couche métallique est intégrée ;
la seconde couche métallique comprend une pluralité de segments séparés les uns des autres, chaque segment comprenant au moins une partie de la première partie et au moins une partie de la seconde partie ; et
les segments de la seconde couche métallique sont fixés à des segments correspondants de la couche de matériau isolant, respectivement.

12. Procédé de fabrication d'un ou plusieurs substrats multicouches, comprenant :
la fourniture d'une couche de matériau isolant (103), d'une première couche métallique (101) et
d'une seconde couche métallique (105), et la disposition de la couche de matériau isolant (103) entre la première couche métallique (101) et la seconde couche métallique (105), dans lequel :
la première couche métallique (101) comprend : une première partie (115) chevauchant la couche de matériau isolant (103), et une seconde partie (117) s'étendant vers l'extérieur à partir de la première partie (115) et s'étendant au-delà de la couche de matériau isolant (103) au moins sur des premier et second côtés opposés de la première couche métallique (101), et la seconde couche métallique (105) comprend : une première partie (125) chevauchant la couche de matériau isolant (103) et destinée à la fixation d'une ou plusieurs puces sur celle-ci, et une seconde partie (127) s'étendant vers l'extérieur à partir de la première partie (125) et s'étendant au-delà de la couche de matériau isolant (103) au moins sur des premier et second côtés opposés de la seconde couche métallique (105) ;
la fixation des première et seconde couches métalliques (101 ; 105) sur deux surfaces opposées de la couche de matériau isolant (103) ;
la réalisation d'un processus de création de motifs sur la seconde couche métallique (105) pour former, dans la seconde partie de la seconde couche métallique (105), au moins une paire de premières encoches (107) s'étendant vers l'intérieur à partir de bords, chaque paire de premières encoches (107) étant située en des positions correspondantes des premier et second côtés de la seconde couche métallique (105), respectivement ;
la réalisation d'un processus de création de motifs sur la première couche métallique (101) pour former, dans la seconde partie (117) de la première couche métallique (101), au moins une paire de secondes encoches (109) s'étendant vers l'intérieur à partir de bords ;
dans lequel chaque paire de secondes encoches (109) est située en des positions correspondantes des premier et second côtés de la première couche métallique (101), respectivement ; et
le sciage de la première couche métallique (101) pour segmenter une pluralité de substrats multicouches.

13. Procédé de fabrication selon la revendication 12, dans lequel la création de motifs de la première couche est réalisée de sorte qu'au moins une encoche parmi chaque première encoche et une seconde encoche correspondante soit adaptée à une forme d'une partie correspondante d'un outil de serrage, de sorte que l'au moins une encoche soit apte à venir solidement en prise avec l'outil de serrage.

14. Procédé de fabrication selon la revendication 13, dans lequel des saillies verticales de chaque paire de secondes encoches sur la seconde couche métallique chevauchent au moins des parties d'une paire correspondante de premières encoches de la seconde couche métallique qui sont destinées à venir en prise avec des outils de serrage.

15. Procédé de fabrication selon la revendication 13, dans lequel :
une largeur d'un bord ouvert de la première encoche est supérieure à celle d'une partie interne de la première encoche dans une direction parallèle au bord ouvert ; et
une largeur d'un bord ouvert de la seconde encoche est supérieure à celle d'une partie interne de la seconde encoche dans une direction parallèle au bord ouvert.

16. Procédé de fabrication selon la revendication 13, dans lequel :
une largeur d'un bord ouvert de la première encoche est inférieure à celle d'au moins une partie d'une partie interne de la première encoche dans une direction parallèle au bord ouvert ; et
une largeur d'un bord ouvert de la seconde encoche est inférieure à celle d'au moins une partie d'une partie interne de la seconde encoche dans une direction parallèle au bord ouvert.

17. Procédé de fabrication selon la revendication 15, dans lequel :
la première encoche comprend deux bords intérieurs s'étendant vers l'intérieur et en regard l'un de l'autre ;
la seconde encoche comprend deux bords intérieurs s'étendant vers l'intérieur et en regard l'un de l'autre ; et
chaque bord intérieur de la première encoche et de la seconde encoche est configuré de sorte que, par rapport à un axe traversant un point le plus intérieur du bord intérieur et parallèle à une direction dans laquelle l'encoche respective s'étend vers l'intérieur, le bord intérieur présente une pente progressivement décroissante au fur et à mesure que le bord intérieur s'étend vers le point le plus intérieur.

18. Procédé de fabrication selon la revendication 17, dans lequel chaque bord intérieur présente l'une des formes suivantes :
un arc qui est non-continument différentiable ; et
une pluralité de segments linéaires présentant des pentes discontinues et reliés en séquence.

19. Procédé de fabrication selon la revendication 13, dans lequel :
le bord intérieur de la première encoche est arqué ; et
le bord intérieur de la seconde encoche est arqué.

20. Module de puissance, comprenant :
(i) un substrat multicouche selon l'une quelconque des revendications 1 à 11,
(ii) une puce comprenant un ou plusieurs dispositifs semiconducteurs de puissance ;
dans lequel la puce est fixée à la première partie de la seconde couche métallique du substrat multicouche.
